(19) Europäisches Patentamt
European Patent Office
Office européen des brevets

(11) **EP 2 541 231 A1**

(12) **EUROPEAN PATENT APPLICATION**
published in accordance with Art. 153(4) EPC

(43) Date of publication:
**02.01.2013 Bulletin 2013/01**

(21) Application number: **11747216.7**

(22) Date of filing: **15.02.2011**

(51) Int Cl.:
**G01N 21/21** *(2006.01)*    **G01N 21/27** *(2006.01)*

(86) International application number:
**PCT/JP2011/053137**

(87) International publication number:
**WO 2011/105252 (01.09.2011 Gazette 2011/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.02.2010 JP 2010040035**

(71) Applicants:
• **Dainippon Screen Mfg. Co., Ltd.**
  **Kyoto-shi, Kyoto 602-8285 (JP)**
• **Gifu University**
  **Gifu-shi**
  **Gifu 501-1193 (JP)**

(72) Inventors:
• **YAMAGUCHI, Shinji**
  **Kyoto-shi**
  **Kyoto 602-8585 (JP)**
• **SUGIMOTO, Yoshio**
  **Kyoto-shi**
  **Kyoto 602-8585 (JP)**
• **FUJIWARA, Hiroyuki**
  **Gifu-shi**
  **Gifu 501-1193 (JP)**

(74) Representative: **Wilhelms · Kilian & Partner**
  **Patentanwälte**
  **Eduard-Schmid-Straße 2**
  **81541 München (DE)**

(54) **HYDROGEN CONTENT RATIO ACQUIRING APPARATUS AND HYDROGEN CONTENT RATIO ACQUIRING METHOD**

(57)    In a hydrogen content acquiring apparatus (1), reference information that associates values of a predetermined group of parameters with SiH and $SiH_2$ contents in a silicon film is generated and stored in advance. By a spectroscopic ellipsometer (3) performing measurement on a silicon film on a glass substrate (9), measured spectra are acquired, and a computer (6) obtains values of the group of parameters from the measured spectra. Then, values of the SiH and $SiH_2$ contents are accurately obtained based on the values of the group of parameters and the reference information.

FIG. 1

## Description

### Technical Field

The present invention relates to a technique for acquiring SiH and $SiH_2$ contents in a silicon film formed on an object.

### Background Art

With increasing attention to global environmental issues in recent years, solar cells that utilize clean sunlight have been developed, and in particular, thin film silicon solar cells that allow increases in surface area and reductions in cost are gathering attention as next-generation solar cells. In the manufacture of thin film silicon solar cells, an amorphous silicon film (hereinafter, simply referred to as a "silicon film") is formed on a glass substrate by chemical vapor deposition (CVD) or the like.

Japanese Patent Application Laid Open Nos. 2003-302334 (Document 1) and 2004-93436 (Document 2) disclose techniques for obtaining optical constants of a homogeneous membrane in a thin-film multilayer structure on a substrate, using the effective medium approximation theory.

Incidentally, it is known that a silicon film formed by CVD contains SiH and $SiH_2$ and that $SiH_2$ can cause photo-deterioration. The $SiH_2$ content in silicon films thus has a significant influence on the conversion efficiency of thin film silicon solar cells. For this reason, it is very important to measure the hydrogen content (in particular, the $SiH_2$ content) in silicon films, in terms of quality control of thin film silicon solar cells.

With an infrared spectrometer, the SiH and $SiH_2$ contents can be measured by acquiring an infrared absorption spectrum of a silicon film formed on a silicon substrate and detecting peaks appearing due to SiH bonding and $SiH_2$ bonding from the spectrum. However, when a silicon film is formed on a glass substrate, accurate measurement of the SiH and $SiH_2$ contents is difficult due to reflection of infrared radiation on the glass substrate. Accordingly, there is demand for a new technique that enables accurate acquisition of the SiH and $SiH_2$ contents even in a silicon film formed on a glass substrate.

### Summary of Invention

The present invention is directed to a hydrogen content acquiring apparatus for acquiring SiH and $SiH_2$ contents in a silicon film formed on an object, and it is an object of the present invention is to provide a new technique that enables accurate acquisition of SiH and $SiH_2$ contents in a silicon film.

The hydrogen content acquiring apparatus according to the present invention is a hydrogen content acquiring apparatus for acquiring SiH and $SiH_2$ contents in a silicon film formed on an object. It includes a spectroscopic ellipsometer, a storage part that stores reference information that associates values of a predetermined group of parameters with SiH and $SiH_2$ contents, and a content calculation part that obtains values of the group of parameters from measured spectra acquired by the spectroscopic ellipsometer performing measurement on a silicon film on an object, and obtains SiH and $SiH_2$ contents based on the values of the group of parameters and the reference information.

According to the present invention, SiH and $SiH_2$ contents in a silicon film can be accurately obtained using the spectroscopic ellipsometer.

In a preferable embodiment of the present invention, one of the group of parameters is a first shift amount that is a difference between a reference peak value that is a peak value of an imaginary part of a dielectric function of a silicon film serving as a reference, and a peak value of an imaginary part of a dielectric function derived from the measured spectra, another one of the group of parameters is a second shift amount that is a difference between a frequency corresponding to the reference peak value and a frequency at the peak of the imaginary part of the dielectric function derived from the measured spectra, and the reference information includes functions that respectively represent SiH and $SiH_2$ contents with the first shift amount and the second shift amount as variables.

In this case, it is preferable that the content calculation part obtains values of the first shift amount and the second shift amount of the silicon film on the object, using an effective medium theory that includes a volume fraction of voids generated in the silicon film due to the presence of SiH and a volume fraction of voids generated in the silicon film due to the presence of $SiH_2$, as parameters. As a result, it is possible to more accurately acquire SiH and $SiH_2$ contents in a silicon film.

In another preferable embodiment of the present invention, the values of the group of parameters include a peak value of an imaginary part of a dielectric function derived from the measured spectra, and a frequency at the peak of the imaginary part.

According to one aspect of the present invention, the object is a substrate for solar cells. In this case, appropriate solar-cell quality control is possible.

The present invention is also directed to a hydrogen content acquiring method for acquiring SiH and $SiH_2$ contents in a silicon film formed on an object.

These and other objects, features, aspects and advantages of the present invention will become more apparent from the following detailed description of the present invention when taken in conjunction with the accompanying drawings.

**Brief Description of Drawings**

Fig. 1 is a perspective view showing a hydrogen content acquiring apparatus;

Fig. 2 shows a configuration of a computer;

Fig. 3 is a block diagram showing a functional configuration implemented by a computer;

Fig. 4 shows dielectric functions of a plurality of silicon films;

Fig. 5 is a flowchart of processing for generating reference information;

Fig. 6 is a flowchart of processing for acquiring the hydrogen content in a silicon film; and

Fig. 7 shows dielectric functions of a silicon film.

**Description of Embodiments**

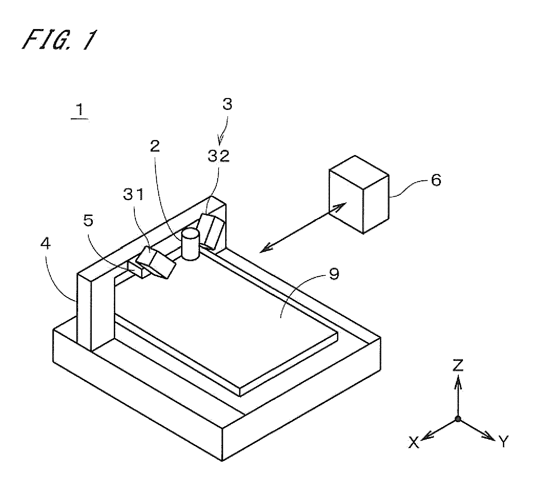

Fig. 1 is a perspective view showing a hydrogen content acquiring apparatus 1 according to an embodiment of the present invention. The hydrogen content acquiring apparatus 1 is configured to acquire SiH and $SiH_2$ contents (hereinafter, also referred to collectively as the "hydrogen content") contained in an amorphous silicon film (hereinafter, simply referred to as a "silicon film") formed on a glass substrate 9 for thin film silicon solar cells. The glass substrate 9 measures, for example, 1 to 2 meters (m) per side.

The hydrogen content acquiring apparatus 1 includes an imaging part 2 that images a surface of the glass substrate 9, a spectroscopic ellipsometer 3 for acquiring measured spectra described later, a Y-direction moving part 4 capable of moving in the Y direction in Fig. 1, an X-direction moving part 5 capable of moving in the X direction in Fig. 1, and a computer 6 configured by, for example, a CPU that performs various types of computational processing and a memory that stores various types of information. The computer 6 functions as a controller that controls the constituent elements of the hydrogen content acquiring apparatus 1. The X-direction moving part 5 is provided on the Y-direction moving part 4, and the imaging part 2 and the spectroscopic ellipsometer 3 are fixed to the X-direction moving part 5. In the hydrogen content acquiring apparatus 1, a position that is irradiated with light by the spectroscopic ellipsometer 3 can be disposed at any position on the glass substrate 9 as intended.

The spectroscopic ellipsometer 3 includes an illumination part 31 and a light receiving part 32 that are disposed above the glass substrate 9 (on the (+Z) side in Fig. 1), the illumination part 31 emitting polarized white light toward the glass substrate 9, and the light receiving part 32 receiving reflected light from the glass substrate 9. The light receiving part 32 includes an analyzer that receives reflected light and a spectroscope that acquires the spectral intensity of reflected light, and the rotational position of the analyzer and the spectral intensity of reflected light acquired by the spectroscope are output to the computer 6. In the computer 6, a phase difference and reflection amplitude ratio angle between p- and s-polarized light components are obtained as a polarized state of each of light rays having a plurality of frequencies (or wavelengths). That is, frequency spectra of the phase difference and the reflection amplitude ratio angle (hereinafter, referred to collectively as "measured spectra") are acquired.

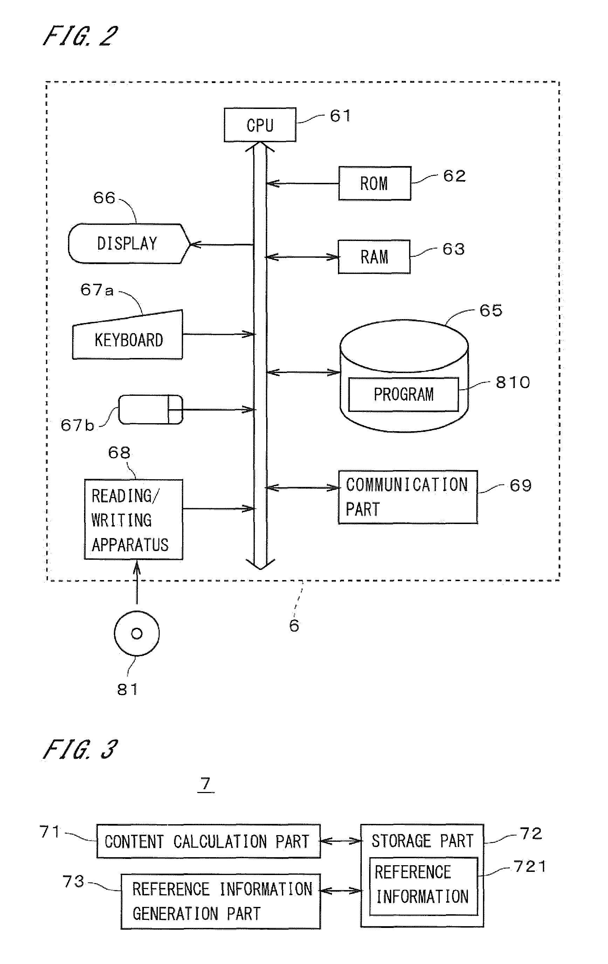

Fig. 2 shows a configuration of the computer 6. The computer 6 is configured as a general computer system in which a CPU 61 that performs various types of computational processing, a ROM 62 that stores base programs, and a RAM 63 that stores various types of information are connected to a bus line. A fixed disk 65 for information storage, a display 66 that displays various types of information, a keyboard 67a and a mouse 67b that receive input from an operator, a reading/writing apparatus 68 that reads or writes information from or to a computer-readable recording medium 81 such as an optical disk, a magnetic disk, or a magneto-optical disk, and a communication part 69 that performs communication with external devices are further connected to the bus line appropriately via an interface (I/F) or the like.

In the computer 6, a program 810 is read from the recording medium 81 via the reading/writing apparatus 68 and stored in the fixed disk 65 in advance. Then, the computer 6 performs processing, serving as a computation part described later, by the program 810 being copied into the RAM 63 and the CPU 61 executing computational processing in accordance with the program in the RAM 63 (i.e., by the computer executing the program).

Fig. 3 is a block diagram showing a functional configuration implemented by, for example, the CPU 61, the ROM 62, the RAM 63, and the fixed disk 65 as a result of the CPU 61 operating in accordance with the program 810. In a calculation part 7 in Fig. 3, a content calculation part 71 and a reference information generation part 73 are functions implemented by the CPU 61 and the like, and the storage part 72 is a function implemented by the fixed disk 65 and the like. Note that the functions of the calculation part 7 may be implemented by a dedicated electrical circuit, or an electrical circuit may be used in part.

Next, the principle of measurement of the hydrogen content performed in the hydrogen content acquiring apparatus 1 will be described. It is assumed here that a plurality of silicon films that differ from one another in at least one of the SiH and SiH$_2$ contents have been prepared by setting the heating temperature of silicon substrates in the CVD process to 310°C, 280°C, 230°C, 180°C, 130°C, and 80°C and sequentially forming silicon films on the silicon substrates. Table 1 shows the SiH and SiH$_2$ contents in the silicon films on the silicon substrates, the column denoted as "substrate Temperature" at the top showing the heating temperature of the silicon substrates when forming the silicon films.

[Table 1]

| Substrate Temperature | SiH Content (at.%) | SiH$_2$ Content (at.%) |
|---|---|---|
| 310°C | 5.3 | 1.1 |
| 280°C | 6.9 | 1.1 |
| 230°C | 7.9 | 3.6 |
| 180°C | 9.0 | 6.1 |
| 130°C | 9.0 | 8.5 |
| 80°C | 9.0 | 13.6 |

As shown in Table 1, the silicon film formed at the lowest heating temperature (substrate temperature of 80°C) has the highest SiH and SiH$_2$ contents (in atomic percents in Table 1), and the silicon film formed at the highest heating temperature (substrate temperature of 310°C) has the lowest SiH and SiH$_2$ contents.

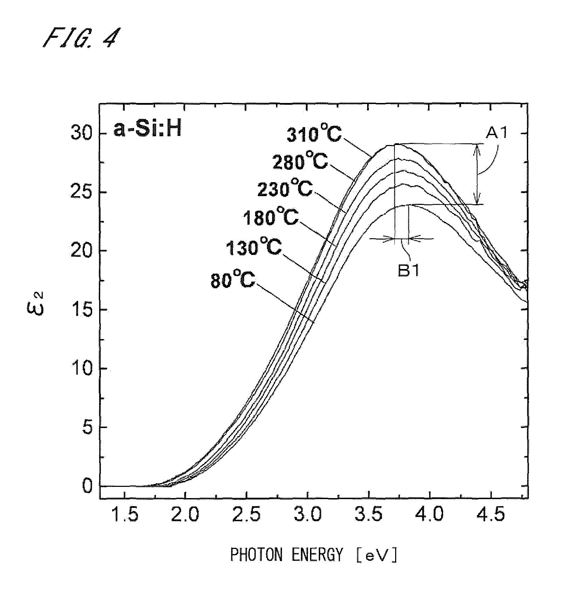

Fig. 4 shows dielectric functions of the above plurality of silicon films. Dielectric function ε is expressed as a complex function with a real part $\varepsilon_1$ and an imaginary part $\varepsilon_2$ (i.e., ($\varepsilon = \varepsilon_1 + i\varepsilon_2$) where i is the imaginary unit). The vertical axis in Fig. 4 indicates the imaginary part $\varepsilon_2$ of the dielectric function, and the horizontal axis indicates photon energy corresponding to the frequency. In Fig. 4, the line indicating the (imaginary part $\varepsilon_2$ of the) dielectric function of each silicon film is given the heating temperature at which the silicon film was formed. Note that the dielectric functions in Fig. 4 are extracted from the measured spectra acquired by the spectroscopic ellipsometer 3, i.e., they are obtained without using a Tauc-Lorentz model described later. Hereinafter, a simply called "dielectric function" represents a complex dielectric function (complex dielectric constant) with the real part and the imaginary part.

As shown in Fig. 4, the dielectric functions of the above silicon films differ from one another, and differences in the values of the imaginary parts $\varepsilon_2$ are evident in the vicinity of the frequencies at the peaks of the imaginary parts $\varepsilon_2$. These differences are considered to depend on differences in the SiH and SiH$_2$ contents. Thus, the present embodiment focuses on differences in the peak values of the imaginary parts $\varepsilon_2$ of a plurality of silicon films and differences in photon energy (or frequency) at the peaks of the imaginary parts $\varepsilon_2$.

Specifically, it is assumed, in the measurement of the hydrogen content by the hydrogen content acquiring apparatus 1, that a silicon film that has the lowest SiH and SiH$_2$ contents, i.e., the silicon film formed at the substrate temperature of 310°C in Table 1 is a reference silicon film serving as a reference. Then, a difference between the peak value of the imaginary part $\varepsilon_2$ of the dielectric function of the reference silicon film (hereinafter, referred to as a "reference peak value") and the peak value of the imaginary part $\varepsilon_2$ of the dielectric function of each of the other silicon films (hereinafter, each referred to as a "sample silicon film") is regarded as one of parameters to be focused on (hereinafter, this difference is referred to as a "first shift amount"). In Fig. 4, the value of the first shift amount of the sample silicon film formed at the heating temperature of 80°C is indicated by the length of an arrow given a reference numeral A1. A difference between the frequency (or photon energy) corresponding to the reference peak value of the reference silicon film and the frequency at the peak of the imaginary part $\varepsilon_2$ of the dielectric function of each sample silicon film is also regarded as another one of the parameters to be focused on (hereinafter, this difference is referred to as a "second shift amount"). In Fig. 4, a value equivalent to the second shift amount of the sample silicon film formed at the heating temperature of 80°C is indicated by the length of an arrow given a reference numeral B1.

Meanwhile, when SiH and SiH$_2$ are contained in a silicon film, voids will be generated in the silicon film due to the presence of each of SiH and SiH$_2$ (i.e., resulting from each of SiH and SiH$_2$). Accordingly, if $f_H$ is the volume fraction of voids generated in a sample silicon film due to the presence of SiH, $f_{HH}$ is the volume fraction of voids generated in the sample silicon film due to the presence of SiH$_2$, $\varepsilon_{310}$ is the dielectric function of the reference silicon film having the lowest SiH and SiH$_2$ contents, and $\varepsilon_b$ is the dielectric function of the vacuum, the dielectric function $\varepsilon_h$ of the sample silicon film with voids is considered to satisfy Eq. 1 according to effective medium approximation.

$$[Eq. 1]$$

$$(1 - f_{HH} - f_H) \frac{\varepsilon_{310} - \varepsilon_h}{\varepsilon_{310} + 2\varepsilon_h} + (f_{HH} + f_H) \frac{\varepsilon_b - \varepsilon_h}{\varepsilon_b + 2\varepsilon_h} = 0$$

Note that although it is also possible in Eq. 1 to take into account the volume fraction and dielectric function of SiH and the volume fraction and dielectric function of $SiH_2$, these parameters have been omitted in Eq. 1 in order to simplify the computation. In Eq. 1, $f_H$ may be regarded as a difference in the volume fraction of voids due to the presence of SiH between the reference silicon film and the sample silicon film (the same applies to $f_{HH}$).

In the hydrogen content acquiring apparatus 1, as preliminary processing, the relationship between the SiH and $SiH_2$ contents and the values of the first and second shift amounts (i.e., reference information 721 in Fig. 3) is derived using Eq. 1. Then, when measuring a silicon film on the glass substrate 9, the values of the first shift amount and the second shift amount of the silicon film are specified using Eq. 1, which makes it possible to accurately acquire the SiH and $SiH_2$ contents in the silicon film. Hereinafter, the generation of the reference information 721 and the measurement of a silicon film on the glass substrate 9 will be described in order in more detail.

Note that the first shift amount of each sample silicon film is considered as a change in the dielectric constant from the dielectric function of the reference silicon film, the change being caused by the presence of voids that depends on SiH and $SiH_2$ (or an increase in the volume fraction of voids when compared with the case of the reference silicon film). Furthermore, since the band gap of a silicon film varies with different hydrogen contents (i.e., the photon energy changes with increasing hydrogen content), the second shift amount is considered to result directly from SiH and $SiH_2$.

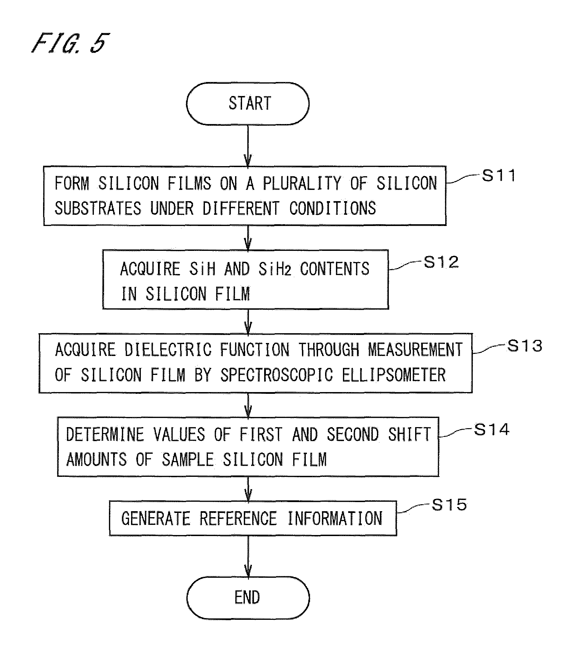

Fig. 5 is a flowchart of the preliminary processing, i.e., the processing for generating the reference information 721. When generating the reference information 721, silicon films are first formed on a plurality of silicon substrates by CVD under different film-forming conditions (step S11). In the present embodiment, as described above, the heating temperatures of silicon substrates in the CVD process are set to 310°C, 280°C, 230°C, 180°C, 130°C, and 80°C, and silicon films are sequentially formed on the silicon substrates. The silicon films formed by CVD are amorphous. Note that the silicon films may contain microcrystalline silicon.

Then, the SiH and $SiH_2$ contents in the silicon film on each of the silicon substrates are acquired by an infrared spectrometer as shown in Table 1 discussed above, and are input to the reference information generation part 73 in Fig. 3 (step S12). A plurality of silicon films that are produced by changing the heating temperature of silicon substrates into multiple different temperatures in the CVD process have different SiH and $SiH_2$ contents. In the present processing as well, the silicon film formed at the substrate temperature of 310°C in Table 1 is referred to as the "reference silicon film", and the other silicon films are referred to as the "sample silicon films". Through the above-described processing of steps S11 and S12, the reference silicon film serving as a reference and whose SiH and $SiH_2$ contents are known, and the other silicon films whose SiH and $SiH_2$ contents are known, are prepared. Note that such a plurality of silicon films having different SiH and $SiH_2$ contents may be produced by changing conditions other than the heating temperature of silicon substrates.

When the plurality of silicon films have been prepared, measurement is performed by the spectroscopic ellipsometer 3 in Fig. 1 emitting polarized white light to a predetermined position (e.g., center) of each silicon film and receiving reflected light from the silicon film, and measured spectra are acquired by the calculation part 7. In the present embodiment, the dielectric function and film thickness based on a Tauc-Lorentz model are fitted within a predetermined numerical range so that the theoretical frequency spectra of the phase difference and the reflection amplitude ratio angle obtained using the Tauc-Lorentz model are closest to the measured spectra. As a result, the dielectric function and film thickness of each silicon film are determined (step S13). Of course, a model other than the Tauc-Lorentz model may be used.

Then, in the reference information generation part 73, the values of the volume fractions $f_H$ and $f_{HH}$ of voids and the dielectric function $\varepsilon_b$ of the vacuum in Eq. 1 above (hereinafter, referred to as an "effective medium theoretical equation") are determined using the dielectric function of each sample silicon film and the dielectric function $\varepsilon_{310}$ of the reference silicon film (hereinafter, referred to as a "reference dielectric function $\varepsilon_{310}$") that have been acquired in the above processing of step S13. At this time, the imaginary part of the dielectric function $\varepsilon_h$ in the effective medium theoretical equation is expressed as the function obtained by moving the imaginary part of the reference dielectric function $\varepsilon_{310}$ by the first shift amount A in the direction of the dielectric constant (vertical axis direction in Fig. 4) and by the second shift amount B in the direction of the frequency (horizontal axis direction in Fig. 4). The real part of the dielectric function $\varepsilon_h$ is also expressed using the reference dielectric function $\varepsilon_{310}$, the first shift amount A, and the second shift amount B, based on Kramers-Kronig relations. Then, the volume fractions $f_H$ and $f_{HH}$ of voids, the dielectric function $\varepsilon_b$ of the vacuum, the first shift amount A, and the second shift amount B are fitted so that the dielectric function $\varepsilon_h$ that is expressed

with the first shift amount A and the second shift amount B and satisfies the effective medium theoretical equation is closest to the acquired dielectric function of the sample silicon film.

In this way, for each of the plurality of sample silicon films, the dielectric function expressed using the effective medium theory (in the present embodiment, effective medium approximation) that includes the first shift amount A and the second shift amount B as parameters is compared with the dielectric function acquired using the Tauc-Lorentz model. As a result, the values of the volume fractions $f_H$ and $f_{HH}$, the first shift amount A, and the second shift amount B of the sample silicon film are determined (step S 14). Note that the dielectric function $\varepsilon_b$ of the vacuum is the same for all the sample silicon films, and determined such that the degree of fitting increases for all the sample silicon films.

In the reference information generation part 73, functions that respectively represent the SiH and $SiH_2$ contents with the first shift amount A and the second shift amount B as variables are generated as the reference information 721 from the values of the first shift amounts A and the second shift amounts B of the plurality of sample silicon films and the SiH and $SiH_2$ contents acquired through the processing of step S12 (step S15). For example, when the SiH content is expressed as ($\alpha1 \cdot A + \alpha2 \cdot B$) and the $SiH_2$ content is expressed as ($\alpha3 \cdot A + \alpha4 \cdot B$), the reference information generation part 73 obtains coefficients $\alpha1$ to $\alpha4$. The reference information 721 is stored in the storage part 72 as preparation for the measurement of an unknown silicon film, which will be described later. In the preliminary processing, there may be also additionally acquired the relationship between the SiH content and the volume fraction $f_H$ and the relationship between the $SiH_2$ content and the volume fraction $f_{HH}$, and these relationships may be included in the reference information 721.

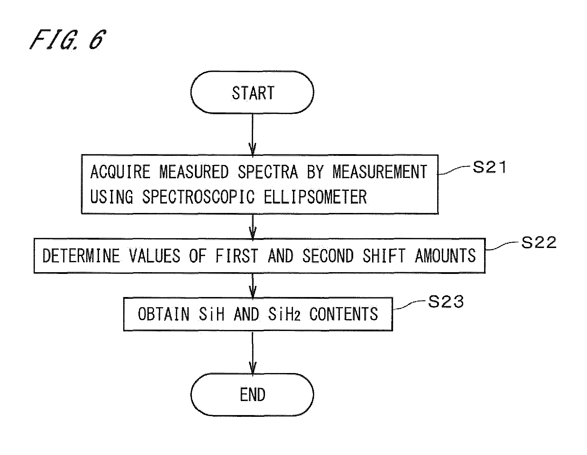

Fig. 6 is a flowchart of the processing for acquiring the SiH and $SiH_2$ contents in a silicon film on the glass substrate 9. When the glass substrate 9 whose SiH and $SiH_2$ contents are unknown is conveyed into the hydrogen content acquiring apparatus 1, the spectroscopic ellipsometer 3 performs measurement on a predetermined position of the silicon film on the glass substrate 9 so as to acquire measured spectra (step S21).

In the content calculation part 71 in Fig. 3, the imaginary part of the dielectric function $\varepsilon_h$ in the effective medium theoretical equation is expressed as the function obtained by moving the imaginary part of the reference dielectric function $\varepsilon_{310}$ by the first shift amount A in the direction of the dielectric constant (vertical axis direction in Fig. 4) and by the second shift amount B in the direction of the frequency (horizontal axis direction in Fig. 4). The real part of the dielectric function $\varepsilon_h$ is also expressed using the first shift amount A and the second shift amount B, based on the Kramers-Kronig relations. Then, while changing the values of the first shift amount A and the second shift amount B that represent the dielectric function $\varepsilon_h$ in the effective medium theoretical equation, the values of the volume fractions $f_H$ and $f_{HH}$ in the effective medium theoretical equation, and the value of a film thickness d of the silicon film into multiple different values, fitting is performed so that the theoretical spectra obtained from these values (i.e., theoretical frequency spectra of the phase difference and the reflection amplitude ratio angle) are closest to the measured spectra. As a result, fitting parameters, namely, the values of the volume fractions $f_H$ and $f_{HH}$, the first shift amount A, the second shift amount B, and the film thickness d of the silicon film, are determined (step S22). As discussed above, the dielectric function $\varepsilon_b$ in the effective medium theoretical equation has been obtained through the processing in Fig. 5.

The above-described fitting processing can be regarded as processing for adapting, to the dielectric function derived from the measured spectra, the dielectric function $\varepsilon_h$ that is expressed by shifting the imaginary part of the reference dielectric function $\varepsilon_{310}$ by the first shift amount A and the second shift amount B in the vertical axis direction and the horizontal axis direction, respectively, in Fig. 4. Thus, it can be said that the first shift amount A is the difference between the reference peak value (peak value of the imaginary part) of the dielectric function of the reference silicon film and the peak value of the imaginary part of the dielectric function derived from the measured spectra (i.e., dielectric function that can be derived from the measured spectra), and that the second shift amount B is the difference between the frequency corresponding to the reference peak value and the frequency at the peak of the imaginary part of the dielectric function derived from the measured spectra.

As discussed above, the reference information 721 includes the functions that respectively represent the SiH and $SiH_2$ contents with the first shift amount A and the second shift amount B as variables. Thus, the values of the SiH and $SiH_2$ contents can be determined by substituting the values of the first shift amount A and the second shift amount B in the functions. That is, the values of the SiH and $SiH_2$ contents are obtained based on the values of the first shift amount A and the second shift amount B, and the reference information 721 (step S23). Furthermore, the dielectric function of the silicon film on the glass substrate 9 can also be obtained from the reference dielectric function $\varepsilon_{310}$ and the values of the first shift amount A and the second shift amount B.

Note that it is also possible to express the first shift amount and the second shift amount, which represent the dielectric function $\varepsilon_h$ in the effective medium theoretical equation, each as the function of the SiH and $SiH_2$ contents (i.e., the dielectric function $\varepsilon_h$ in the effective medium theoretical equation is expressed using the SiH and $SiH_2$ contents as parameters) and to directly obtain the values of the SiH and $SiH_2$ contents through the fitting processing of step S22. In this case as well, it can be considered that the SiH and $SiH_2$ contents are substantially obtained based on the values of the first shift amount A and the second shift amount B. and the reference information 721.

Table 2 shows the measurement results from the hydrogen content acquiring apparatus 1 and the measurement results from an external infrared spectrometer, the column denoted as "Spectroscopic Ellipsometry" at the top showing the measurement results from the hydrogen content acquiring apparatus 1, and the column denoted as "Infrared Spectroscopy" at the top showing the measurement results from the infrared spectrometer. Since it is difficult for the infrared spectrometer to measure a silicon film on a glass substrate, Table 2 shows the results of measurement performed on a silicon film formed by CVD (plasma CVD) on a native oxide film of a silicon substrate. The SiH and $SiH_2$ contents acquired by the hydrogen content acquiring apparatus 1 almost match those acquired by the infrared spectrometer.

[Table 2]

|  | Spectroscopic Ellipsometry | Infrared Spectroscopy |
|---|---|---|
| SiH Content (at.%) | 8.9 | 8.8 |
| $SiH_2$ Content (at.%) | 8.1 | 8.1 |

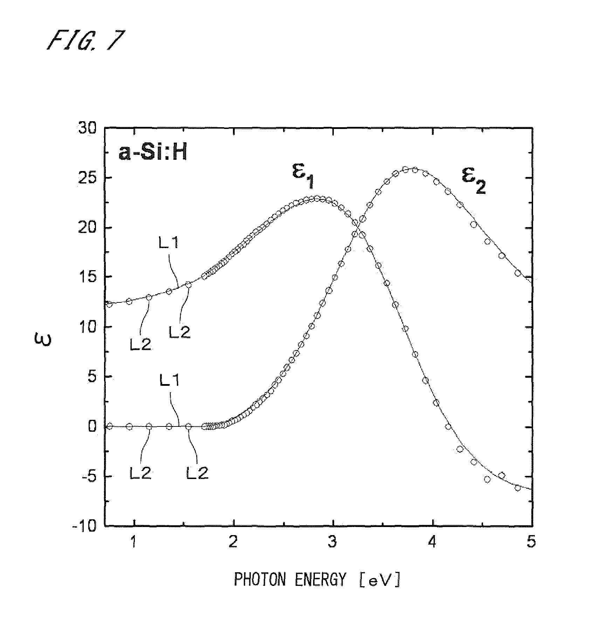

Fig. 7 shows dielectric functions of the silicon film on the above silicon substrate. Solid lines given a reference numeral L1 in Fig. 7 represent the dielectric function obtained by the hydrogen content acquiring apparatus 1 using the effective medium theoretical equation, and a plurality of circles given a reference numeral L2 in Fig. 7 represent the dielectric function extracted from the measured spectra acquired by the spectroscopic ellipsometer 3 (dielectric function derived without using the effective medium theoretical equation). A left-side bell-shaped curve in Fig. 7 represents the real part $\varepsilon_1$ of the dielectric function, and a right-side bell-shaped curve represents the imaginary part $\varepsilon_2$. It can be seen from Fig. 7 that the dielectric function obtained by the hydrogen content acquiring apparatus 1 using the effective medium theoretical equation closely matches the dielectric function extracted from the measured spectra, and therefore, the dielectric function can be appropriately obtained.

As described above, in the hydrogen content acquiring apparatus 1, the reference information 721 that associates the values of a group of parameters including the first shift amount and the second shift amount with the SiH and $SiH_2$ contents is stored. Furthermore, measured spectra are acquired by the spectroscopic ellipsometer 3 performing measurement on a silicon film on the glass substrate 9. Accordingly, the values of the group of parameters are obtained from the measured spectra, and the values of the SiH and $SiH_2$ contents are obtained based on the values of the group of parameters and the reference information 721. In this way, the hydrogen content acquiring apparatus 1 is capable of accurately obtaining the SiH and $SiH_2$ contents in a silicon film, using the spectroscopic ellipsometer 3. This enables appropriate quality control of solar cells manufactured using the glass substrate 9.

Incidentally, Japanese Patent Application Laid Open Nos. 2003-302334 and 2004-93436 (Documents 1 and 2 described above) disclose effective medium approximation models in which it is assumed that a film to be analyzed is configured by a simple mixture of a plurality of materials. By contrast, the present embodiment constructs an effective medium theoretical equation that takes into account voids generated due to the presence of SiH and the presence of $SiH_2$ in a silicon film. Furthermore, the present embodiment uses a characteristic dielectric function model that expresses the dielectric function $\varepsilon_h$ in the effective medium theoretical equation using the first shift amount and the second shift amount as parameters, thereby making it possible to easily and accurately obtain the SiH and $SiH_2$ contents.

Here, consider the case in which the hydrogen content (i.e., SiH and $SiH_2$ contents) in a silicon film is measured using an infrared spectrometer. If the silicon film is formed on a glass substrate, accurate measurement of the hydrogen content is difficult because of reflection of infrared radiation on the glass substrate. Furthermore, with infrared spectroscopy, if a multilayer film is formed on a substrate, it is difficult to measure the hydrogen content. Moreover, since the size of the infrared spectrometer is large, moving the spectrometer and performing measurement in a wide range of the substrate is difficult, and in order to perform measurement on each portion of the substrate, that portion needs to be cut out and set in the infrared spectrometer.

In contrast, in the hydrogen content acquiring apparatus 1 in Fig. 1, since the SiH and $SiH_2$ contents in a silicon film are acquired using the spectroscopic ellipsometer 3, accurate measurement is possible even if the silicon film is formed on a glass substrate. Furthermore, even if a multilayer film is formed on a substrate, the SiH and $SiH_2$ contents can be acquired by, through fitting, obtaining the values of the first shift amount and the second shift amount of a silicon film constituting one layer of the multilayer film. Moreover, since the spectroscopic ellipsometer 3 is smaller than the infrared spectrometer, moving the spectroscopic ellipsometer 3 (without cutting out a portion of the substrate) and performing measurement in a wide range of the substrate can be easily realized. In this way, no constraints such as the type and size of an object on which a silicon film is formed are imposed on the measurement of the hydrogen content by the hydrogen content acquiring apparatus 1, and even if a silicon film is part of a multilayer film, it is possible to measure the hydrogen content. In addition, the hydrogen content acquiring apparatus 1 is also capable of acquiring the thickness, optical constants and the like of a silicon film simultaneously with the hydrogen content therein.

Next, another exemplary processing performed by the hydrogen content acquiring apparatus 1 will be described.

In the preliminary processing according to the present exemplary processing, when the dielectric functions of the reference silicon film and a plurality of other sample silicon films have been acquired using the Tauc-Lorentz model in step S13 in Fig. 5, the difference between the reference peak value, which is the peak value of the imaginary part of the dielectric function of the reference silicon film, and the peak value of the imaginary part of the dielectric function of each sample silicon film is obtained as the value of the first shift amount, and the difference between the frequency corresponding to the reference peak value and the frequency at the peak of the imaginary part of the dielectric function of the sample silicon film is obtained as the value of the second shift amount (step S14). In other words, the values of the first shift amount and the second shift amount of each sample silicon film are obtained without using the effective medium theoretical equation. Then, as in the above-described exemplary processing, reference information that associates the values of the first shift amount and the second shift amount with the SiH and $SiH_2$ contents is generated (step S15).

Next, when measuring a silicon film on the glass substrate 9, the spectroscopic ellipsometer 3 performs measurement on the silicon film so as to acquire measured spectra (Fig. 6: step S21). Then, the dielectric function (i.e., dielectric function of the silicon film on the glass substrate 9) is acquired from the measured spectra using the Tauc-Lorentz model, the difference between the reference peak value of the reference silicon film and the peak value of the imaginary part of that dielectric function is obtained as the value of the first shift amount, and the difference between the frequency corresponding to the reference peak value and the frequency at the peak of the imaginary part of that dielectric function is obtained as the value of the second shift amount (step S22). Then, the SiH and $SiH_2$ contents are specified based on the values of the first shift amount and the second shift amount, and the reference information (step S23). In this way, in the present exemplary processing, the SiH and $SiH_2$ contents in a silicon film are obtained without using the effective medium theoretical equation.

The hydrogen content acquiring apparatus 1 may also be configured such that reference information that associates the peak value of the imaginary part of the dielectric function of each sample silicon film and the frequency at the peak of the imaginary part with the SiH and $SiH_2$ contents is prepared, and when measuring the hydrogen content, the SiH and $SiH_2$ contents are obtained based on the peak value of the imaginary part of the dielectric function that is acquired by the spectroscopic ellipsometer 3 performing measurement on a silicon film on the glass substrate 9, on the frequency at the peak of the imaginary part, and on the reference information. In this way, even if the values of the group of parameters obtained when acquiring the hydrogen content include the peak value of the imaginary part of the dielectric function derived from the measured spectra and the frequency at the peak of the imaginary part, the hydrogen content acquiring apparatus 1 is capable of acquiring the SiH and $SiH_2$ contents with a certain degree of accuracy. However, in order to more accurately acquire the SiH and $SiH_2$ contents in a silicon film, it is preferable to obtain the values of the first shift amount and the second shift amount of a silicon film while using the effective medium theoretical equation as in the above-described exemplary processing.

While the above has been a description of embodiments of the present invention, the present invention is not intended to be limited to the above-described embodiments and can be modified in various ways.

In step S15 in Fig. 5, if $R_H$ is a difference in the SiH content between the reference silicon film and each sample silicon film and $R_{HH}$ is a difference in the $SiH_2$ content therebetween, functions that respectively represent $R_H$ and $R_{HH}$ with the first shift amount A and the second shift amount B as variables may be acquired as the reference information. In this case, in step S23 in Fig. 6, the values of $R_H$ and $R_{HH}$ are obtained from the values of the first shift amount A and the second shift amount B of the silicon film on the glass substrate 9, and the SiH and $SiH_2$ contents in the reference silicon film are added respectively to the values of $R_H$ and $R_{HH}$. As a result, the SiH and $SiH_2$ contents in the silicon film on the glass substrate 9 are calculated. Substantially, it can also be said that these functions respectively represent the SiH and $SiH_2$ contents, using the first shift amount A and the second shift amount B as variables.

In step S12 in Fig. 5, the SiH and $SiH_2$ contents in a silicon film may be acquired by a technique other than infrared spectroscopy.

The hydrogen content acquiring apparatus 1 is capable of acquiring the SiH and $SiH_2$ contents in a silicon film formed on various types of objects such as substrates for solar cells other than the glass substrate 9, and plastic films, and the like. Furthermore, a silicon film may be formed by a method other than CVD.

The configurations of the above-described preferred embodiments and variations may be appropriately combined as long as there are no mutual inconsistencies.

While the invention has been shown and described in detail, the foregoing description is in all aspects illustrative and not restrictive. It is therefore understood that numerous modifications and variations can be devised without departing from the scope of the invention.

**Reference Signs List**

| 1 | Hydrogen content acquiring apparatus |

| | |
|---|---|
| 3 | Spectroscopic ellipsometer |
| 9 | Glass substrate |
| 71 | Content calculation part |
| 72 | Storage part |
| 721 | Reference information |
| S11 to S15, S21 to S23 | Step |

**Claims**

1. A hydrogen content acquiring apparatus (1) for acquiring SiH and $SiH_2$ contents in a silicon film formed on an object (9), comprising:

   a spectroscopic ellipsometer (3);
   a storage part (72) that stores reference information (721) that associates values of a predetermined group of parameters with SiH and $SiH_2$ contents; and
   a content calculation part (71) that obtains values of said group of parameters from measured spectra acquired by said spectroscopic ellipsometer performing measurement on a silicon film on an object, and obtains SiH and $SiH_2$ contents based on the values of said group of parameters and said reference information.

2. The hydrogen content acquiring apparatus according to claim 1, wherein
   one of said group of parameters is a first shift amount that is a difference between a reference peak value that is a peak value of an imaginary part of a dielectric function of a silicon film serving as a reference, and a peak value of an imaginary part of a dielectric function derived from said measured spectra,
   another one of said group of parameters is a second shift amount that is a difference between a frequency corresponding to said reference peak value and a frequency at the peak of the imaginary part of the dielectric function derived from said measured spectra, and
   said reference information includes functions that respectively represent SiH and $SiH_2$ contents with said first shift amount and said second shift amount as variables.

3. The hydrogen content acquiring apparatus according to claim 2, wherein
   said content calculation part obtains values of said first shift amount and said second shift amount of the silicon film on said object, using an effective medium theory that includes a volume fraction of voids generated in the silicon film due to the presence of SiH and a volume fraction of voids generated in the silicon film due to the presence of $SiH_2$, as parameters.

4. The hydrogen content acquiring apparatus according to claim 1, wherein
   the values of said group of parameters include a peak value of an imaginary part of a dielectric function derived from said measured spectra, and a frequency at the peak of the imaginary part.

5. The hydrogen content acquiring apparatus according to any one of claims 1 to 4, wherein
   said object is a substrate for solar cells.

6. A hydrogen content acquiring method for acquiring SiH and $SiH_2$ contents in a silicon film formed on an object (9), comprising the steps of:

   a) (S11 to S15) preparing reference information (721) that associates values of a predetermined group of parameters with SiH and $SiH_2$ contents;
   b) (S21, S22) acquiring measured spectra by a spectroscopic ellipsometer (3) performing measurement on a silicon film on an object, and obtaining values of said group of parameters from said measured spectra; and
   c) (S23) obtaining SiH and $SiH_2$ contents based on said values of said group of parameters and said reference information.

7. The hydrogen content acquiring method according to claim 6, wherein
one of said group of parameters is a first shift amount that is a difference between a reference peak value that is a peak value of an imaginary part of a dielectric function of a silicon film serving as a reference, and a peak value of an imaginary part of a dielectric function derived from said measured spectra,
another one of said group of parameters is a second shift amount that is a difference between a frequency corresponding to said reference peak value and a frequency at the peak of the imaginary part of the dielectric function derived from said measured spectra, and
said reference information includes functions that respectively represent SiH and $SiH_2$ contents with said first shift amount and said second shift amount as variables.

8. The hydrogen content acquiring method according to claim 7, wherein
in said step b), values of said first shift amount and said second shift amount of the silicon film on said object are obtained using an effective medium theory that includes a volume fraction of voids generated in the silicon film due to the presence of SiH and a volume fraction of voids generated in the silicon film due to the presence of $SiH_2$, as parameters.

9. The hydrogen content acquiring method according to claim 8, wherein
said step a) includes the steps of:

a1) (S11, S12) preparing a reference silicon film serving as said reference and whose SiH and $SiH_2$ contents are known, and a plurality of other sample silicon films whose SiH and $SiH_2$ contents are known;
a2) (S13) for each of said reference silicon film and said plurality of sample silicon films, performing measurement using said spectroscopic ellipsometer so as to acquire a dielectric function;
a3) (S14) for each of said plurality of sample silicon films, comparing a dielectric function expressed using said effective medium theory that includes said first shift amount and said second shift amount as parameters with the dielectric function acquired in said step a2), so as to determine values of said first shift amounts and said second shift amounts of said plurality of sample silicon films; and
a4) (S15) generating said functions that respectively represent SiH and $SiH_2$ contents with said first shift amount and said second shift amount as variables, from the values of said first shift amounts and said second shift amounts of said plurality of sample silicon films.

10. The hydrogen content acquiring method according to claim 6, wherein
the values of said group of parameters include a peak value of an imaginary part of a dielectric function derived from said measured spectra, and a frequency at the peak of the imaginary part.

11. The hydrogen content acquiring method according to any one of claims 6 to 10, wherein
said object is a substrate for solar cells.

*FIG. 1*

*FIG. 2*

```
              ┌─────┐
              │ CPU │── 61
              └─────┘
                 ↑
                 │         ┌─────┐
       66        │    ┌───→│ ROM │── 62
        │        │    │    └─────┘
  ┌──────────┐   │    │
  │ DISPLAY  │←──┤    │    ┌─────┐
  └──────────┘   │    ├───↔│ RAM │── 63
                 │    │    └─────┘
   67a           │    │
    │            │    │              ── 65
 ┌──────────┐    │    │      ┌─────────┐
 │ KEYBOARD │────┼───→│    ╱            ╲
 └──────────┘    │    ├──↔ │             │
                 │    │     │ ┌─────────┐ │
                 │    │     │ │ PROGRAM │─┼─ 810
    ┌───┐        │    │     │ └─────────┘ │
    │   │────────┼───→│      ╲           ╱
    └───┘        │    │       └─────────┘
 67b             │    │
                 │    │    ┌──────────────┐
   68            │    │    │ COMMUNICATION│── 69
    │            │    └───↔│ PART         │
 ┌───────────┐   │    │    └──────────────┘
 │ READING/  │   │    │
 │ WRITING   │───┼───→│
 │ APPARATUS │   │    │
 └───────────┘   ↓
       ↑
      ┌─┐
      │○│
      └─┘
       │
      81
```

                                        6

*FIG. 3*

                    7

```
71 ┌────────────────────────┐      ┌──────────────────┐── 72
   │ CONTENT CALCULATION PART│←───↔│  STORAGE PART    │
   └────────────────────────┘      │ ┌──────────────┐ │── 721
73 ┌────────────────────────┐      │ │ REFERENCE    │ │
   │ REFERENCE INFORMATION  │←───↔│ │ INFORMATION  │ │
   │ GENERATION PART        │      │ └──────────────┘ │
   └────────────────────────┘      └──────────────────┘
```

## FIG. 4

*FIG. 5*

```
                    ┌─────────────┐
                    │    START    │
                    └─────────────┘
                           │
                           ▼
┌──────────────────────────────────────────────┐
│ FORM SILICON FILMS ON A PLURALITY OF SILICON  │── S11
│ SUBSTRATES UNDER DIFFERENT CONDITIONS         │
└──────────────────────────────────────────────┘
                           │
                           ▼
        ┌──────────────────────────────────┐
        │ ACQUIRE SiH AND SiH2 CONTENTS     │── S12
        │ IN SILICON FILM                   │
        └──────────────────────────────────┘
                           │
                           ▼
┌──────────────────────────────────────────────────────┐
│ ACQUIRE DIELECTRIC FUNCTION THROUGH MEASUREMENT       │── S13
│ OF SILICON FILM BY SPECTROSCOPIC ELLIPSOMETER         │
└──────────────────────────────────────────────────────┘
                           │
                           ▼
    ┌──────────────────────────────────────────┐
    │ DETERMINE VALUES OF FIRST AND SECOND SHIFT│── S14
    │ AMOUNTS OF SAMPLE SILICON FILM            │
    └──────────────────────────────────────────┘
                           │
                           ▼
      ┌────────────────────────────────────┐
      │ GENERATE REFERENCE INFORMATION      │── S15
      └────────────────────────────────────┘
                           │
                           ▼
                    ┌─────────────┐
                    │     END     │
                    └─────────────┘
```

## FIG. 6

```
┌──────────────┐
│    START     │
└──────────────┘
        │
        ▼
┌─────────────────────────────────────────────┐
│ ACQUIRE MEASURED SPECTRA BY MEASUREMENT      │──S21
│ USING SPECTROSCOPIC ELLIPSOMETER             │
└─────────────────────────────────────────────┘
        │
        ▼
┌─────────────────────────────────────────────┐
│ DETERMINE VALUES OF FIRST AND SECOND SHIFT AMOUNTS │──S22
└─────────────────────────────────────────────┘
        │
        ▼
┌─────────────────────────────────────────────┐
│ OBTAIN SiH AND SiH₂ CONTENTS                 │──S23
└─────────────────────────────────────────────┘
        │
        ▼
┌──────────────┐
│     END      │
└──────────────┘
```

FIG. 7

**EP 2 541 231 A1**

<table>
<tr><td colspan="2" style="text-align:center"><strong>INTERNATIONAL SEARCH REPORT</strong></td><td>International application No.<br>PCT/JP2011/053137</td></tr>
</table>

| A. CLASSIFICATION OF SUBJECT MATTER |
|---|
| *G01N21/21*(2006.01)i, *G01N21/27*(2006.01)i |

According to International Patent Classification (IPC) or to both national classification and IPC

| B. FIELDS SEARCHED |
|---|

Minimum documentation searched (classification system followed by classification symbols)
G01N21/00-21/61, H01L31/04-31/06

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
WPI, JSTPlus(JDreamII)

| C. DOCUMENTS CONSIDERED TO BE RELEVANT |
|---|

| Category* | Citation of document, with indication, where appropriate, of the relevant passages | Relevant to claim No. |
|---|---|---|
| X<br>A | JP 7-12714 A (Fuji Electric Co., Ltd.),<br>17 January 1995 (17.01.1995),<br>paragraphs [0016], [0032], [0034], [0044];<br>fig. 2<br>(Family: none) | 1,6<br>2-5,7-11 |
| A | JP 2005-283502 A (Horiba, Ltd.),<br>13 October 2005 (13.10.2005),<br>entire text<br>& US 2005/0219529 A1 & KR 2005-0096847 A<br>& TW 278617 B | 1-11 |

☒ Further documents are listed in the continuation of Box C. ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>29 March, 2011 (29.03.11) | Date of mailing of the international search report<br>26 April, 2011 (26.04.11) |
|---|---|
| Name and mailing address of the ISA/<br>Japanese Patent Office | Authorized officer |
| Facsimile No. | Telephone No. |

Form PCT/ISA/210 (second sheet) (July 2009)

17

**EP 2 541 231 A1**

<table>
<tr><td colspan="2" align="center">**INTERNATIONAL SEARCH REPORT**</td><td>International application No.<br>PCT/JP2011/053137</td></tr>
</table>

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2004-335867 A  (Shin-Etsu Handotai Co., Ltd.),<br>25 November 2004 (25.11.2004),<br>entire text<br>& US 2007/0186970 A1     & US 2010/0173447 A<br>& EP 1630873 A1          & WO 2004/100273 A1<br>& KR 2006-0064561 A      & CN 1784789 A<br>& AU 2004237524 A | 1-11 |
| A | JP 2003-203957 A  (Fujitsu Ltd.),<br>18 July 2003 (18.07.2003),<br>entire text<br>& JP 6-341952 A          & US 5595916 A | 1-11 |
| A | JP 11-14543 A  (Shin-Etsu Handotai Co., Ltd.),<br>22 January 1999 (22.01.1999),<br>entire text<br>(Family: none) | 1-11 |
| P,X | Shota KAGEYAMA, Hiroyuki FUJIWARA, "Bunko Ellipsometry ni yoru Glass Kiban-jo a-Si:H So no Suisoryo Hyoka", Dai 71 Kai Extended abstracts; the Japan Society of Applied Physics, 30 August 2010 (30.08.2010), page 16-059, thesis no. 14p-ZB-3 | 1,2,5-7,11 |
| P,X | Shota KAGEYAMA, Hiroyuki FUJIWARA, "Usumaku Taiyo Denchi-yo a-Si:H So no Ellipsometry Hyoka", Dai 57 Kai Extended Abstracts, Japan Society of Applied Physics and Related Societies, 03 March 2010 (03.03.2010), page 16-054, thesis no. 18a-TG-1 | 1,2,5-7,11 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003302334 A

- JP 2004093436 A